# EUROPÄISCHE PATENTSCHRIFT

(11) **EP 2 576 429 B1**
(45) Veröffentlichungstag und Bekanntmachung des Hinweises auf die Patenterteilung: **14.06.2017**
(21) Anmeldenummer: 11714281.0
(22) Anmeldetag: 13.04.2011
(51) Int. Cl.: B81C 1/00

(54) **BAUELEMENT MIT EINER DURCHKONTAKTIERUNG UND VERFAHREN ZU DESSEN HERSTELLUNG**
COMPONENT WITH A VIA AND METHOD FOR PRODUCING IT
COMPOSANT COMPORTANT UN CONTACT TRAVERSANT ET SON PROCÉDÉ DE FABRICATION

(30) Priorität: 31.05.2010 DE 102010029504
(43) Veröffentlichungstag der Anmeldung: 10.04.2013
(73) Patentinhaber: Robert Bosch GmbH, 70442 Stuttgart (DE)
(72) Erfinder: GONSKA, Julian, 72766 Reutlingen (DE); SCHLOSSER, Roman, 79183 Waldkirch (DE); FREY, Jens, 70794 Filderstadt (DE); WEBER, Heribert, 72622 Nuertingen (DE); GRAF, Eckhard, 72810 Gomaringen (DE)
(86) Internationale Anmeldenummer: PCT/EP2011/055825
(87) Internationale Veröffentlichungsnummer: WO 2011/151098

(56) Entgegenhaltungen:
- US-A1- 2008 157 361

## Beschreibung

### Stand der Technik

Die Erfindung betrifft ein Bauelement, dessen Funktionalität in einem Schichtaufbau auf einem leitfähigen Substrat realisiert ist, mit mindestens einer auf die Bauelementrückseite geführten Durchkontaktierung (Vertical Interconnect Access VIA) zur elektrischen Kontaktierung von im Schichtaufbau realisierten Funktionselementen. Die Durchkontaktierung umfasst einen Anschlussbereich im Substrat, der sich über die gesamte Substratdicke erstreckt und durch einen sich ebenfalls über die gesamte Substratdicke erstreckenden, grabenförmigen Isolationsrahmen gegenüber dem angrenzenden Substrat elektrisch isoliert ist.

Die Erfindung betrifft ferner ein Verfahren zur Herstellung eines Bauelements mit einer derartigen Durchkontaktierung.

Außerdem betrifft die Erfindung ein Bauelement mit Funktionselementen, die in einem Schichtaufbau auf einem Substrat realisiert sind, und mit einem leitfähigen Kappensubstrat auf dem Schichtaufbau.

Es ist bekannt, elektrische Kontaktierungen durch einen Wafer oder einen Teilbereich eines Wafers durchzuführen. Diese Art der Kontaktierung wird beispielsweise bei Bauelementen eingesetzt, die für eine Flip-Chip-Montage bestimmt sind. Durchkontaktierungen ermöglichen aber auch dreidimensionale Verpackungskonzepte, bei denen mehrere Bauelemente vertikal übereinander angeordnet und kontaktiert werden. Deshalb gewinnen Durchkontaktierungen zunehmend an Bedeutung.

In der europäischen Patentanmeldung EP 1 671 924 A2 wird ein mikromechanisches Sensorelement der eingangs genannten Art beschrieben, dessen mikromechanische Strukturelemente in einer Funktionsschicht des Schichtaufbaus realisiert sind. Dabei handelt es sich um ineinandergreifende Interdigitalstrukturen mit feststehenden und auslenkbaren Elektroden. Zum elektrischen Anschluss dieser Elektroden sind zwischen dem Substrat und der strukturierten Funktionsschicht Leiterbahnen in den Schichtaufbau integriert. Diese Leiterbahnen stehen jeweils mit einem eine Durchkontaktierung bildenden Anschlussbereich des Substrats in unmittelbarem Kontakt. Jeder Anschlussbereich ist vollständig von Gräben umgeben, die nach der Fertigstellung des Schichtaufbaus in einem Rückseitentrenchprozess im Substrat erzeugt wurden und sich über die gesamte Substratdicke erstrecken. Diese Gräben bilden einen Isolationsrahmen, der den Anschlussbereich gegenüber dem angrenzenden Substrat elektrisch isoliert. Der Isolationsrahmen der in der EP 1671 924 A2 beschriebenen Durchkontaktierungen wird allenfalls oberflächlich verfüllt, und zwar mit dem Material einer Isolationsschicht, die nach dem Rückseitentrenchprozess und vor einer Metallisierung auf die Substratrückseite aufgebracht und strukturiert wird, so dass die Metallisierung mit dem Anschlussbereich in Verbindung steht.
Diese Realisierungsform einer Durchkontaktierung erweist sich in der Praxis in zweierlei Hinsicht als problematisch. Zum einen sind die Isolationseigenschaften von offenen Gräben undefiniert. Diese können beispielsweise durch eine Verschmutzung beim Herstellungs- bzw. Vereinzelungsprozess oder auch am Einsatzort des Bauelements beeinträchtigt werden, so dass die elektrische Zuverlässigkeit der Durchkontaktierung leidet. Zum anderen hängt die mechanische Stabilität von Durchkontaktierungen mit einem offenen Isolationsrahmen wesentlich ab von dessen Geometrie, d.h. von dessen Form, Tiefe und Breite. Die mechanische Stabilität einer Durchkontaktierung muss aber beispielsweise für eine externe Kontaktierung durch Drahtbonden immer dieselben Mindestanforderungen erfüllen.

Die Patentveröffentlichung US 5,910,522 A1 beschreibt ein Bauelement mit eine Durchkontaktierung in einem Substrat, wobei die Durchkontaktierung durch polymergefüllte Grabenbereiche vom umgebenden Substrat isoliert wird.

### Offenbarung der Erfindung

Erfindungsgemäße Vorrichtungen sind in den Ansprüchen 1 und 2 definiert; Das erfindungsgemäße Verfahren ist wie in Anspruch 10 definiert.

Mit der vorliegenden Erfindung wird eine vorteilhafte Möglichkeit zur Realisierung von elektrisch sehr zuverlässigen und mechanisch stabilen Durchkontaktierungen bei Bauelementen der eingangs genannten Art vorgeschlagen.
Die angestrebte elektrische Zuverlässigkeit und mechanische Stabilität der Durchkontaktierungen wird erfindungsgemäß durch Verfüllen des grabenförmigen Isolationsrahmens mit einem elektrisch isolierenden Polymer erreicht.
Erfindungsgemäß ist zunächst erkannt worden, dass eine hinreichende mechanische Stabilität der bekannten Durchkontaktierungen am einfachsten durch Verfüllen des Isolationsrahmens erzielt werden kann. Im Hinblick auf die Montage der hier in Rede stehenden Bauelemente ist dabei darauf zu achten, dass die Bauelementrückseite auch im Bereich der Durchkontaktierungen möglichst topographiefrei ist. Außerdem sollte die Verfüllung möglichst lunkerfrei sein, um eine optimale elektrische Isolation der Durchkontaktierung zu erreichen. Verfüllmaterial und Verfüllprozess sind so zu wählen, dass die Umgebung der Durchkontaktierung auch bei mittleren Temperaturen nicht kontaminiert wird.
Erfindungsgemäß ist dann erkannt worden, dass sich elektrisch isolierende Polymere sowohl aufgrund ihrer elektrischen und mechanischen Eigenschaften als auch aufgrund der Verfahren, die zum Verfüllen von Trenchgräben mit einem hohen Aspektverhältnis zur Verfügung stehen, besonders gut zur Isolation der bekannten Durchkontaktierungen eignen.
Unter Zugrundelegung des voranstehend erläuterten Erfindungsgedankens wird außerdem vorgeschlagen, eine derartige Durchkontaktierung im leitfähigen Kappensubstrat eines entsprechend ausgestatteten Bauelements zu realisieren, so dass dieses Bauelement über seine Kappe kontaktierbar ist.
Als besonders geeignete Polymere seien an dieser Stelle BCB (Benzocyclobuten), ALX-211 Polymere der Fa. Asahi, Polyimide und PBO (Polyphenylen-2,6-benzobisoxazol) sowie deren Schichtkombinationen genannt. Diese Materialien lassen sich einfach unter Vakuum-Bedingungen auf die Substratrückseite aufschleudern oder aufsprühen, wobei Trenchgräben, wie Isolationsrahmen, sukzessive aufgefüllt werden.

Diese Materialien weisen sehr gute dielektrische Eigenschaften auf. Da sie nach dem Aushärten temperatur- und auch feuchtestabil sind, eignen sie sich gut für den Einsatz im Automotivebereich. Auch im Rahmen des Herstellungsverfahrens erweist sich ihre Verwendung als vorteilhaft, da sie ein vollständiges lunkerfreies Verfüllen der Isolationsgräben ermöglichen, Vakuum tauglich sind und eine gute Benetzung für eine Belackung ermöglichen. Außerdem besitzen diese Materialien eine angepasste thermisch kontrollierbare Viskosität.

Aufgrund der polymeren Verfüllung des Isolationsrahmens weist die Durchkontaktierung eine hinreichende mechanische Stabilität in allen drei Raumrichtungen auf, die ein direktes Drahtbonden auf der metallisierten Oberfläche der Durchkontaktierung ermöglicht. Dies kommt einem flächensparenden Bauelementaufbau zu Gute und erleichtert eine platzsparende Montage. In diesem Zusammenhang erweist es sich außerdem als vorteilhaft, dass die Topographie der Bauelementrückseite im Bereich um die Durchkontaktierung typischerweise kleiner ist als 1-10µm.

Die thermische Fehlanpassung von Silizium (CTE = 3·10⁻⁶K⁻¹) und einem zum Verfüllen des Isolationsrahmens verwendeten Polymer (CTE = 60·10⁻⁶K⁻¹) wirkt sich negativ auf die mechanische Stabilität der Silizium-Durchkontaktierungen aus. Um die mechanische Stabilität der erfindungsgemäßen Durchkontaktierungen zu erhöhen, kann die thermische Dehnung (CTE) polymerer Materialien durch Zugabe von geeigneten Füllstoffen zum Polymer-Basismaterial reduziert werden. Dafür eignen sich insbesondere SiO2-Nanopartikel oder Metalloxid Partikel. Auf diese Weise lassen sich auch Polymermaterialien synthetisieren, die eine negative thermische Ausdehnung aufweisen, um besonders niedrige CTEs zu realisieren. Dabei sind hohe Füllgrade und Füllstoffmischungen mit definierter Korngrößenverteilung sowie die gute Verarbeitbarkeit der Composite sicherzustellen.

Grundsätzlich lassen sich erfindungsgemäße Bauelemente mit Durchkontaktierungen in jeder Form, Geometrie und Anordnung realisieren. Besonders vorteilhaft für die mechanische Robustheit ist es, wenn der Isolationsrahmen der Durchkontaktierung eine gerundete Geometrie aufweist, insbesondere zylinderförmig ist. Zylinderförmige Durchkontaktierungen haben den Vorteil, dass sie die kleinsten Parasitärkapazitäten gegenüber dem Substrat bzw. gegenüber benachbarten Durchkontaktierungen besitzen.

Des Weiteren kann die mechanische Stabilität der Durchkontaktierung durch eine zusätzliche Verankerung der Polymerverfüllung im Isolationsrahmen erhöht werden. Dazu wird der Isolationsrahmen im Bereich der Mitte und/oder seines Fußpunktes durch anteilig isotropes Tiefenätzen erweitert. Die resultierende Grabengeometrie im Mittelbereich und/oder am Fußpunkt bewirkt eine sehr gute mechanische Stressentkopplung im Übergangsbereich zwischen dem Substrat und dem Schichtaufbau. Insbesondere bei Isolationsrahmen mit radialer Geometrie werden die mechanischen Spannungen gleichmäßig in der Grenzfläche zwischen dem Substrat und dem Schichtaufbau verteilt.

Mit der voranstehend beschriebenen Technologie lassen sich besonders vorteilhaft Durchkontaktierungen mit einem Kontaktwiderstand von 2-100 Ohm realisieren. Dazu ist das Substratmaterial im Anschlussbereich vorzugsweise hochdotiert. Die Durchkontaktierung steht vorteilhafterweise mit einer im Schichtaufbau realisierten Leiterbahn in Verbindung, die beispielsweise in Form einer geeignet dotierten und strukturierten Polysiliziumschicht realisiert sein kann. In einer besonders vorteilhaften Ausführungsform der Erfindung ist die Kontaktfläche der mechanischen Verbindung zwischen dem Substratmaterial im Anschlussbereich, also der Durchkontaktierung, und der vergrabenen Polysilizium-Leiterbahn vergrößert, indem die Substratoberfläche in diesem Bereich vor dem Aufbringen des Polysiliziums strukturiert, also beispielsweise mit Stufen oder Sicken, versehen wurde. Derartige Strukturen tragen ebenso in vorteilhafter Weise zur Versteifung, Stabilisierung und Verankerung des Unterbaus bzw. des Sockels der Durchkontaktierung bei.

Des Weiteren steht die Durchkontaktierung in einer bevorzugten Ausführungsform der Erfindung mit einer auf die Bauelementrückseite aufgebrachten Metallisierung in Verbindung, in der ein Anschlusspad zur externen Kontaktierung ausgebildet ist. Dieses Anschlusspad kann direkt auf der vertikalen Durchkontaktierung positioniert sein oder auch mit Hilfe einer Umverdrahtung an einer anderen Stelle der Bauelementrückseite. Die Kontaktvariante mit Umverdrahtung bietet einen höheren Freiheitsgrad beim Positionieren der Anschlusspads, was beispielsweise bei der Flip-Chip-Montage oder beim Aufeinanderstapeln von Bauelementen ausgenutzt werden kann.

Wesentlich ist, dass sich das erfindungsgemäße Konzept einer Durchkontaktierung sowohl für reine IC-Bauelemente als auch für mikromechanische Bauelemente und MEMS eignet, solange deren Funktionalität in einem Schichtaufbau auf einem leitfähigen Substrat realisiert ist oder der Bauelementaufbau ein leitfähiges Kappensubstrat umfasst, in dem die Durchkontaktierung realisiert wird.

Dazu wird im Rahmen der Vorderseitenprozessierung des Herstellungsverfahrens mindestens eine Leiterbahn im Schichtaufbau auf dem Halbleitersubstrat realisiert, die einerseits in unmittelbarem Kontakt zu einem Anschlussbereich im Substrat steht und andererseits eine elektrische Verbindung zu mindestens einem im Schichtaufbau zu realisierenden Funktionselement herstellt. Erst nach der Fertigstellung des Schichtaufbaus mit der Funktionalität des Bauelements und nach Verkappen mit dem Kappensubstrat wird die Bauelementrückseite prozessiert. Im Rahmen dieser Rückseitenprozessierung wird dann ein den Anschlussbereich umgebender, sich über die gesamte Substratdicke (typischerweise 50-300 µm) erstreckender Isolationsrahmen im Substrat erzeugt. Dieser grabenförmige Isolationsrahmen wird erfindungsgemäß mit einem elektrisch isolierenden Polymer - möglichst vollständig - verfüllt. Außerdem wird eine Metallisierung auf die Bauelementrückseite aufgebracht, die mit dem Anschlussbereich in Verbindung steht und in der ein Anschlusspad zur externen Kontaktierung des Bauelements ausgebildet wird.
Die großflächige Verbindung von Halbleitersubstrat und vergrabener Leiterbahn, die Abstützung der polymeren Verfüllung und die Art des Polymers sorgen für maximale mechanische Stabilität der Durchkontaktierung.

In einer besonders vorteilhaften Verfahrensvariante wird die Metallisierung vor dem Rückseitentrenchprozess auf die Bauelementrückseite aufgebracht und so strukturiert, dass sie eine Ätzmaske für den Rückseitentrenchprozess bildet. Die strukturierte Metallisierung dient hier also zunächst als höchst selektive Trenchmaske für einen high-aspect-Trenchprozess, die präzise Grabenätzungen für Aspektverhältnisse oberhalb 1/40 ermöglicht. Das Ätzen der Isolationsrahmen bei moderatem Aspektverhältnis von typischerweise 1/20 kann unter Verwendung der bekannten Fotolacktechnik erfolgen.

Da der Isolationsrahmen erst am Ende des Rückseitenprozesses verfüllt wird, wenn keine Hochtemperaturschritte mehr erfolgen, sind nicht mehr so hohe Anforderungen an die thermische Beständigkeit des Verfüllmaterials zu stellen. Diese Verfahrensvariante ist kompatibel mit den bekannten MEMS- und CMOS-Prozessen. Da weder der Trenchprozess noch das Verschließen der Isolationsrahmen hohe Prozesstemperaturen benötigen, können auch Bauelemente mit temperaturempfindlichen Funktionselementen nachträglich wie hier beschrieben mit Durchkontaktierungen versehen werden.
Von besonderem Vorteil ist außerdem, dass bei dieser Verfahrensvariante ein großes Prozessfenster für das Trenchätzen des Isolationsrahmens und das Verfüllen des Isolationsrahmens zur Verfügung steht, da nur moderate Strukturbreiten notwendig sind und mit geeigneten Verfüllverfahren sehr breite Gräben, typischerweise 5-30µm, verschlossen werden können.

### Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die den unabhängigen Patentansprüchen nachgeordneten Patentansprüche verwiesen und andererseits auf die nachfolgende Beschreibung zweier Ausführungsbeispiele der Erfindung anhand der Figuren.
- **Fig. 1a bis 1f**: veranschaulichen die Herstellung eines erfindungsgemäßen Bauelements anhand von schematischen Schnittansichten des Bauelementaufbaus im Bereich einer Durchkontaktierung in aufeinander folgenden Stadien des Herstellungsverfahrens.
- **Fig. 2**: zeigt eine schematische Schnittansicht des so gefertigten Bauelements im Bereich einer Durchkontaktierung mit unmittelbar auf der Durchkontaktierung positioniertem Drahtbond.
- **Fig. 3a**: zeigt eine schematische Schnittansicht eines weiteren so gefertigten Bauelements im Bereich einer Durchkontaktierung mit Umverdrahtung und
- **Fig. 3b**: eine Draufsicht auf die Anschlussmetallisierung dieses Bauelements.
- **Fig. 4a**: zeigt eine schematische Schnittdarstellung eines erfindungsgemäßen Bauelements mit leitfähigem Kappenwafer im Bereich einer Durchkontaktierung durch diesen Kappenwafer und
- **Fig. 4b**: zeigt eine Draufsicht auf die Ebene der vergrabenen Leiterbahn im Bereich der Durchkontaktierung.
- **Fig. 5**: zeigt eine schematische Schnittdarstellung eines weiteren erfindungsgemäßen Bauelements mit einem leitfähigen Kappenwafer und Anschlussmöglichkeiten auf der Bauelementoberseite und auf der Bauelementrückseite.

### Ausführungsformen der Erfindung

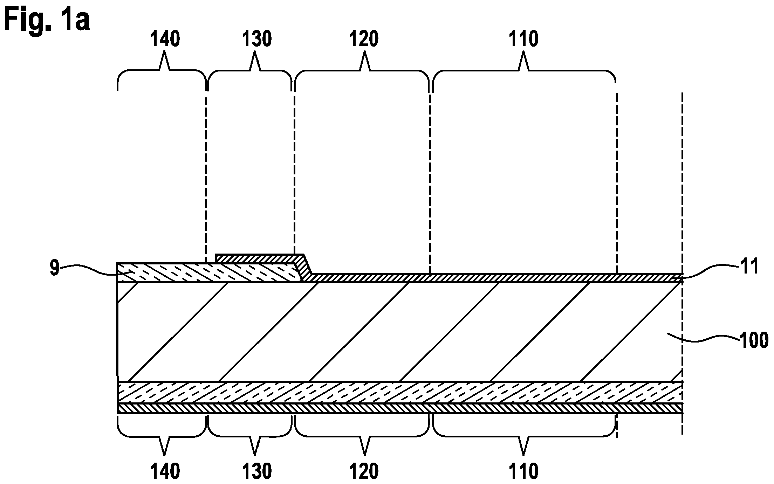

Das beanspruchte Verfahren zur Herstellung eines Bauelements der hier in Rede stehenden Art geht von einem vorzugsweise hochdotierten Halbleitersubstrat 100 aus, wie es in **Fig. 1a** dargestellt ist. Im Rahmen der Vorderseitenprozessierung wird zunächst eine dielektrische Schicht 9 auf der Substratoberfläche erzeugt. Dazu wird beispielsweise eine TEOS-Schicht abgeschieden oder SiO2 aufoxidiert. Im Rahmen einer Strukturierung der dielektrischen Schicht 9 wird diese in den Bereichen geöffnet, in denen ein Kontakt zum Substrat 100 hergestellt werden soll, und zwar in den Bereichen einer noch zu erzeugenden Durchkontaktierung und eines Bondrahmens, die in Fig. 1a mit 120 und 110 bezeichnet sind. Der Kontakt wird mit Hilfe von einer oder auch mehreren Leiterbahnen 11 hergestellt. Diese werden vorzugsweise in einer Polysiliziumschicht 11 realisiert, die beispielsweise in einem LPCVD-Verfahren auf der strukturierten dielektrischen Schicht 9 abgeschieden wird. Zur Verbesserung der mechanischen Verbindung zwischen dem Substrat 100 und der Polysiliziumschicht 11 im Bereich 120 können in diesem Bereich 120 vor dem Abscheiden des Polysiliziums beispielsweise noch konzentrisch verlaufende Stufen, sogenannte Sicken, beispielsweise geätzt werden.
Im hier beschriebenen Ausführungsbeispiel wird die Polysiliziumschicht 11 dann so strukturiert, dass der Bereich 120 der noch zu erzeugenden Durchkontaktierung und der Bereich 110 des Bondrahmens elektrisch miteinander verbunden bleiben und eine vorteilhafte Topographie nach Planarisieren der Oberfläche der Funktionsschicht entsteht. Außerdem wird in der Polysiliziumschicht 11 ein Kontaktbereich 130 herausstrukturiert für eine noch zu erzeugende mikromechanische Sensorstruktur in einem Sensorbereich 140 des Bauelements.

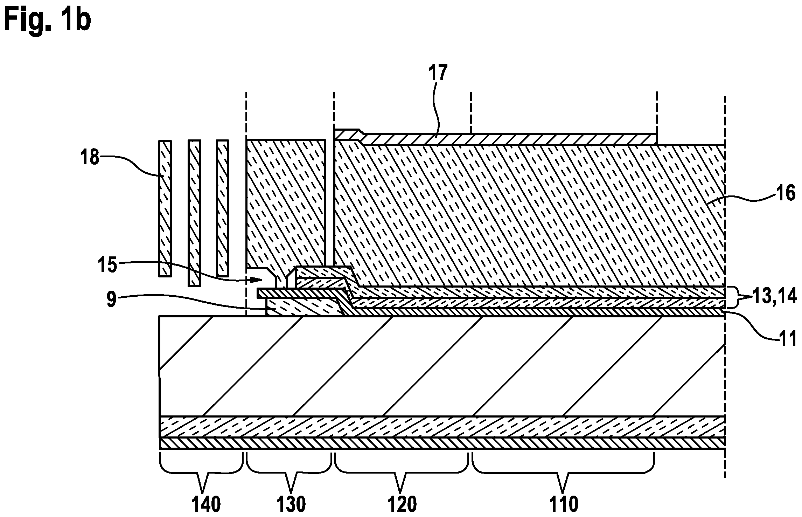

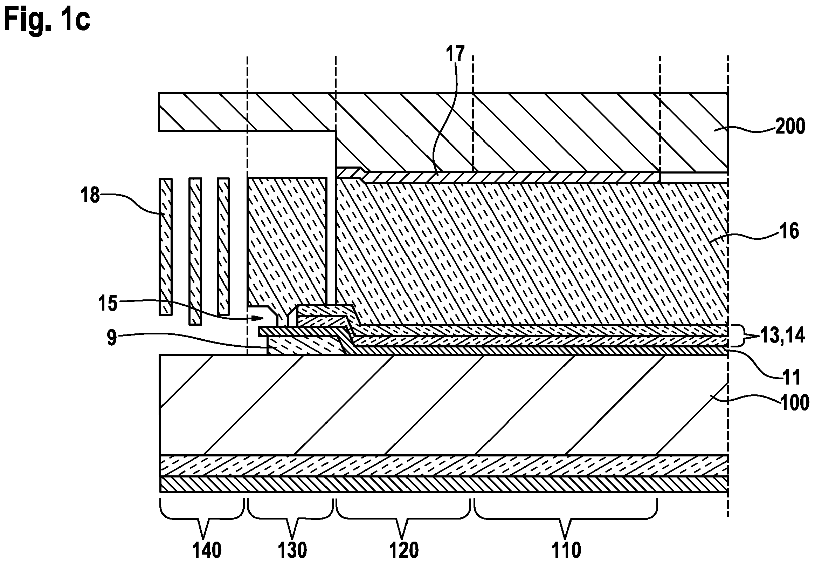

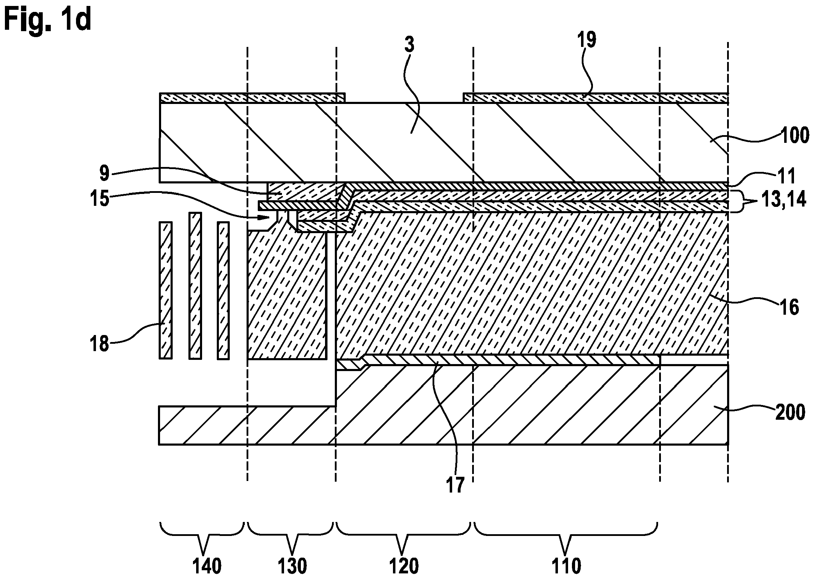

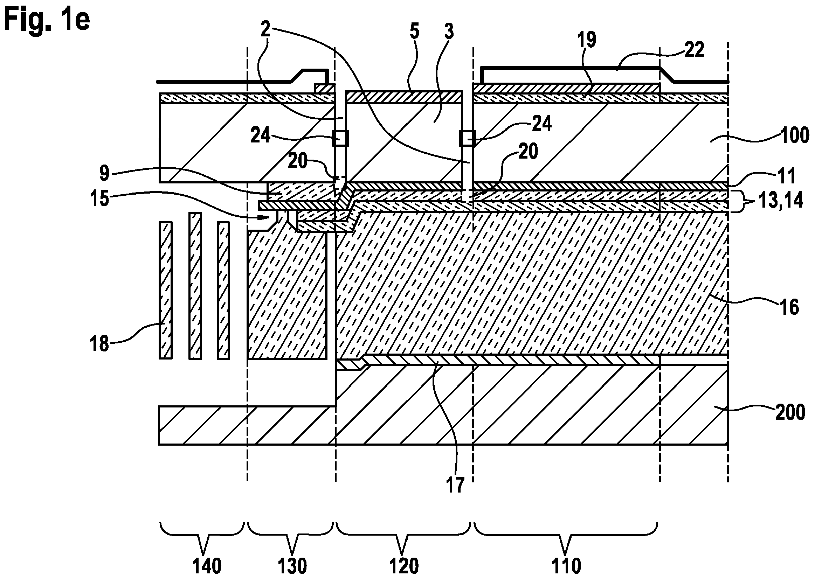

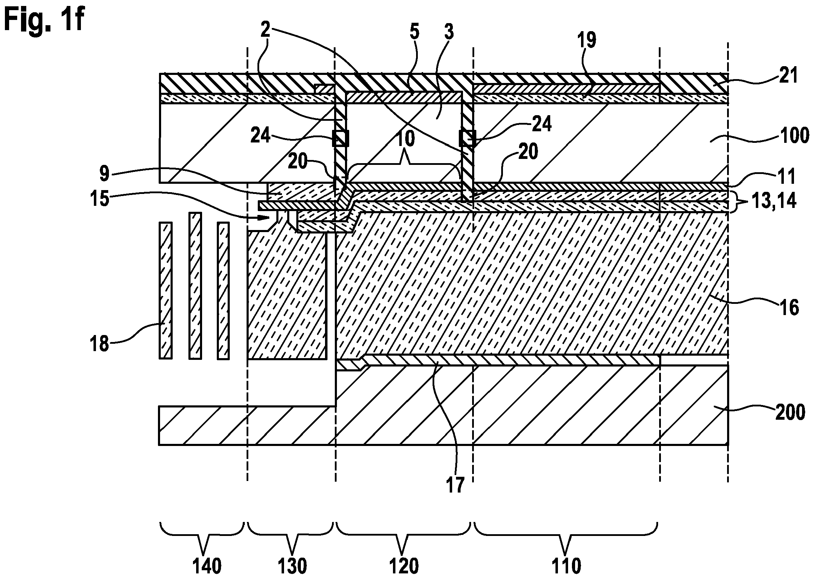

Fig. 1 **b** zeigt den Schichtaufbau, nachdem über der Polysilizium-Leiterbahnschicht 11 eine oder auch mehrere dielektrische Schichten 13, 14 abgeschieden worden sind und im Rahmen einer Strukturierung dieser Schichten 13, 14 eine Kontaktöffnung 15 im Kontaktbereich 130 erzeugt worden ist, die auf die vergrabene Leiterbahn 11 mündet. In einer bekannten oberflächenmikromechanischen Prozessfolge wurde dann in einer Funktionsschicht 16 des Schichtaufbaus eine mikromechanische Sensorstruktur 18 erzeugt. Diese Sensorstruktur 18 steht über die Kontaktöffnung 15 mit der Leiterbahn 11 in Verbindung. In den Bereichen des Bondrahmens 110 und der Durchkontaktierung 120 wurde im hier beschriebenen Ausführungsbeispiel schließlich noch eine Metallisierung 17 auf die Funktionsschicht 16 aufgebracht.

Die Metallisierung 17 dient als Bondmetall zur Montage eines Kappenwafers 200 über der Sensorstruktur 18 mittels eutektischem Bonden. Für die Montage des Kappenwafers 200 kann aber auch jede andere Waferbondtechnik angewandt werden. Wie aus **Fig. 1c** ersichtlich, müssen der Kappenwafer 200 und die Sensorstruktur 18 des Bauelements präzise zueinander justiert sein. Sie sind über die eutektisch gebondete Metallisierung 17 auch elektrisch miteinander verbunden. Die Vorderseitenprozessierung des Bauelements ist mit der Montage des Kappenwafers 200 abgeschlossen.

Im Rahmen der nun folgenden Rückseitenprozessierung wird zunächst die Rückseite des Substrats 100 rückgedünnt. Dazu werden bevorzugt bekannte Verfahren, wie Schleifen, chemisches Ätzen, trocken Ätzen und/oder chemisch mechanisches Polieren, eingesetzt. Typischerweise wird das Substrat 100 dabei auf eine Dicke von 50 bis 300µm abgedünnt. Die Dicke des Substrats 100 wird insbesondere durch die angestrebte mechanische Stabilität des Bauelements und die maximal mögliche Tiefe der nachfolgend für die Durchkontaktierungen zu erzeugenden Trenchgräben bestimmt.

Die Durchkontaktierung bzw. der Isolationsrahmen der Durchkontaktierung muss justiert zu der vergrabenen Leiterbahn 11 positioniert werden. Dazu werden Justagemarken auf die Substratrückseite übertragen, beispielsweise mittels Infrarot-Justage bezogen auf die Metallisierung 17 im Bereich 120.
Im hier beschriebenen Ausführungsbeispiel wird nun eine dielektrische Zwischenschicht 19 auf die Substratrückseite aufgebracht und im markierten Bereich 120 der zu erzeugenden Durchkontaktierung 3 geöffnet. Dabei handelt es sich vorzugsweise um eine dünne CVD oder Polymerschicht mit einer Stärke von 100nm bis 1000nm. Diese Situation ist in **Fig. 1d** dargestellt.

Über der so strukturierten dielektrischen Zwischenschicht 19 wird eine Metallschicht 5 abgeschieden und strukturiert. Da in der Metallschicht 5 die Anschlusspads zur externen Kontaktierung des Bauelements bzw. der Sensorstruktur 18 realisiert werden, wird hier ein drahtbondbares Metall verwendet, vorzugsweise Al, AlSi, AlCu, AlSiCu, TiN sowie andere Edel- und Halbedelmetalle. Die Metallschicht 5 kann hier außerdem zusammen mit der dielektrischen Zwischenschicht 19 als Maske für den nachfolgenden anisotropen Trenchprozess verwendet werden, in dem der Isolationsrahmen 2 für die Durchkontaktierung 3 im Substrat 100 erzeuget wird. Deshalb wird die Metallschicht 5 über den zu erzeugenden Trenchgräben 2 ganz oder zumindest teilweise geöffnet. Wenn das Anschlusspad unmittelbar auf der zu erzeugenden Durchkontaktierung positioniert werden soll, kann die Metallschicht 5 über dem gesamten umlaufenden Isolationsrahmen geöffnet werden. Alternativ kann die Lackmaske 22 die Metallschicht 5 abdecken und zur Strukturierung der dielektrischen Zwischenschicht 19 und des Substrats 100 verwendet werden. Soll aber eine Umverdrahtung erfolgen, d.h. soll das Anschlusspad seitlich von der Durchkontaktierung auf der Substratrückseite angeordnet werden, dann verbleibt bei der Strukturierung der Metallschicht 5 zweckmäßigerweise zumindest ein nach außen führender Steg als elektrische Verbindung zum außerhalb des Isolationsrahmens liegenden Anschlusspad. Die Proportionen derartiger Stege und die Prozessparameter für die Ätz- und Passivierungsschritte des Trenchprozesses werden so gewählt, dass die Stege in der strukturierten Metallschicht 5 vollständig unterätzt werden. Alternativ kann die Unterätzung auch in einem nachfolgenden isotropen Ätzschritt erfolgen.

Der Isolationsrahmen 2 wurde hier in einem mehrstufigen Trenchprozess erzeugt. Durch Kombination von anisotropen und längeren isotropen Ätzschritten in definierter Tiefe des Isolationsrahmens 2 wurden am Fußpunkt 20 und im Mittelbereich 24 taschenartige Erweiterungen zur Verankerung des Polymers 21 im Isolationsrahmen 2 erzeugt.
Ätzen und Abrunden durch anteilig isotropes Tiefenätzen der dielektrischen Schichten 9, 13, 14 schafft zusätzlich eine Verankerung für die Polymerverfüllung 21 an der Basis 20 des Isolationsrahmens 2 und damit für die Durchkontaktierung 3. Zum Schutz der übrigen metallfreien Substratbereiche wurde eine Lackmaske 22 verwendet.

**Fig. 1e** zeigt den Bauelementaufbau, nach dem Rückseitentrenchprozess und verdeutlicht, dass sich der Isolationsrahmen 2 über die gesamte Dicke des Substrats 100 erstreckt bis in die dielektrische Schicht 9 bzw. die dielektrischen Schichten 13, 14, welche auch als Ätzstopp dienen. Auf diese Weise wird ein Anschlussbereich des hochdotierten Substrats 100 vom angrenzenden Substratmaterial elektrisch isoliert und bildet so eine Durchkontaktierung 3, die über die Leiterbahn 11 mit der Sensorstruktur 18 verbunden ist.

Erfindungsgemäß wird der Isolationsrahmen 2 nun mit einem elektrisch isolierenden Polymer, wie beispielsweise BCB, verfüllt. Dazu wird eine entsprechende Polymerschicht 21 unter Vakuum-Bedingungen aufgeschleudert oder auch aufgesprüht. Dabei wird der Isolationsrahmen 2 fortschreitend aufgefüllt. Die Dicke der Polymerschicht 21 wird so gewählt, dass auch die größten Öffnungen bzw. Hohlräume des Trenchgrabens 2 bis zu einer Breite von 30µm vollständig geschlossen werden. Vorzugsweise wird der Isolationsrahmen 2 so verfüllt, dass der gesamte Schichtaufbau mit dielektrischen Schichten, Silizium und Polymerverfüllung des Bauelements eine angepasste thermische Ausdehnung (CTE) besitzt. Die Stabilität dieses in **Fig. 1f** dargestellten Polymerverschlusses erhöht sich, wenn keine Einschlüsse vorhanden sind und wenn die Kontaktfläche 10 zwischen der Durchkontaktierung 3, d.h. dem Anschlussbereichs des Substrats 100, und der vergrabenen Leiterbahn 100 möglichst groß ist. Die Polymerverfüllung 21 ist hier durch die taschenartigen Erweiterungen 20 und 24 des Trenchgrabens 2 besonders gut verankert.

Schließlich werden noch die Kontakt- bzw. Bondflächen der Durchkontaktierung 3 geöffnet, beispielsweise durch vollflächiges Rückdünnen der Polymerschicht 21 oder auch mittels Fotostrukturierung im Bereich der Bondflächen.

An dieser Stelle sei angemerkt, dass nach dem Verfüllen des Isolationsrahmens 2 grundsätzlich auch noch weitere Bearbeitungsschritte auf der Bauelementvorderseite und/oder -rückseite vorgenommen werden können.

Alternativ zu dem voranstehend beschriebenen Rückseitenprozess besteht auch die Möglichkeit, den Isolationsgraben vor dem Aufbringen einer Rückseitenmetallisierung zu erzeugen und mit einem Polymer zu verfüllen. Die Bauelementrückseite kann dann erst noch planarisiert werden, bevor weitere Schichten zur Realisierung der Anschlusspads aufgebracht werden. Zur Planarisierung werden bevorzugt Verfahren wie Feinschleifen oder mechanisch/chemisches Polieren eingesetzt.

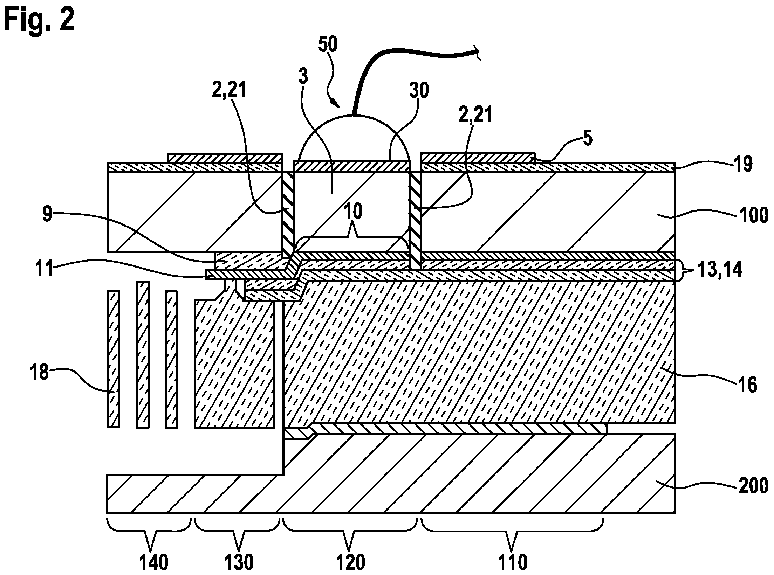

In **Fig. 2** ist das Ergebnis des voranstehend beschriebenen Herstellungsverfahrens in Form eines Bauelements dargestellt. Dabei handelt es sich um ein Beschleunigungssensorelement, dessen mikromechanische Funktionselemente 18 im Schichtaufbau auf dem Halbleitersubstrat 100 realisiert worden sind. Die mikromechanischen Funktionselemente 18 werden durch den Kappenwafer 200 geschützt, der beispielsweise durch eutektisches Bonden auf dem Schichtaufbau des Bauelements montiert worden ist. Die elektrische Kontaktierung der mikromechanischen Funktionselemente 18 erfolgt über die vergrabene Leiterbahn 11 die durch dielektrische Schichten 9 und 13, 14 einerseits gegen das hochdotierte Halbleitersubstrat 100 und andererseits gegen die Funktionsschicht 16 mit den Funktionselementen 18 elektrisch isoliert ist. Die Leiterbahn 11 stellt eine Verbindung zwischen den mikromechanischen Funktionselementen 18 und einem Anschlussbereich 3 des Substrats 100 her, der durch einen zylindrischen Isolationsrahmen 2 gegen das angrenzende Substratmaterial isoliert ist und die Durchkontaktierung bildet. Der Unterbau der Funktionsschicht 16 weist im Bereich 120 und 110 eine allenfalls sehr niedrige (<500nm) Topographie auf. Dadurch wird erreicht, dass die Metallisierung in diesem Bereich auch praktisch topographiefrei ist, was Voraussetzung für eine hermetisch dichte eutektische Bondverbindung zum Kappenwafer 200 ist.
Der Isolationsrahmen 2 ist erfindungsgemäß mit einem dielektrischen Polymer 21 verfüllt. Auf der Substratrückseite befindet sich eine strukturierte Metallisierung 5, die in unmittelbarem Kontakt zum Anschlussbereich 3 steht aber ansonsten durch eine dielektrische Schicht 19 gegen das Substrat 100 elektrisch isoliert ist. Das Anschlusspad 30 zur externen Kontaktierung des Bauelements bzw. der Funktionselemente 18 ist hier direkt auf dem Anschlussbereich 3 positioniert, der aufgrund der Polymerverfüllung 21 so weit mechanisch stabilisiert ist, dass eine direkte Drahtbondung 50 auf der Durchkontaktierung 3 möglich ist, was in Fig. 2 dargestellt ist. Die Metallisierung 5 ist hier so strukturiert, dass das Anschlusspad 30 inselartig vom Rest der Metallisierung 5 abgetrennt ist. Die außerhalb des Padbereichs liegende Metallisierung 5 dient als Maske für den Trenchprozess zum Erzeugen des Isolationsrahmens. Diese Metallisierung ist dann nicht erforderlich, wenn aufgrund eines geringeren Aspektverhältnisses auch eine Lackmaske verwendet werden kann.

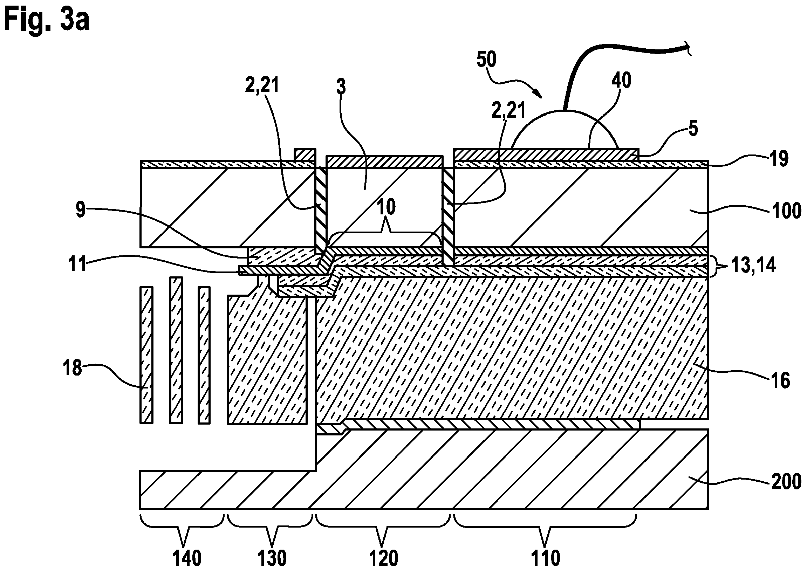

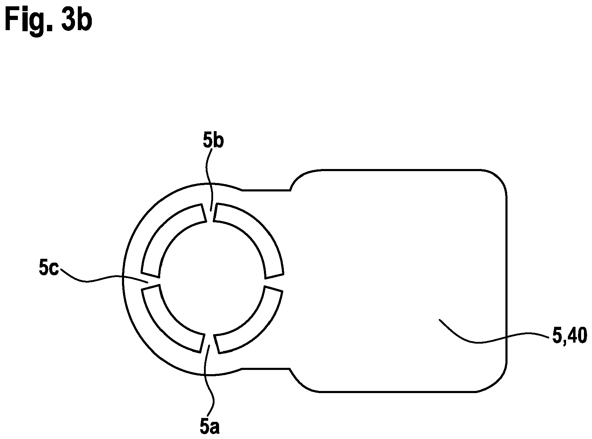

In **Fig. 3a** werden dieselben Bezugszeichen wie in Fig. 2 verwendet, da die beiden hier dargestellten Bauelemente identisch aufgebaut sind. Sie unterscheiden sich lediglich in der Strukturierung der Metallisierung 5 bzw. durch die Anordnung des Anschlusspads zur externen Kontaktierung.
Während das Anschlusspad 30 im Fall der Fig. 2 direkt auf der Durchkontaktierung 3 positioniert ist, ist das Anschlusspad 40 des in Fig. 3a dargestellten Bauelements seitlich von der Durchkontaktierung 3 angeordnet. Dementsprechend befindet sich auch die Drahtbondung 50 seitlich von der Durchkontaktierung 3. Zur Realisierung des Anschlusspads 40 seitlich von der Durchkontaktierung 3 war eine Umverdrahtung erforderlich, die durch **Fig. 3b** veranschaulicht wird. Der Bereich der Metallisierung 5, der in unmittelbarem Kontakt zum Anschlussbereich 3 steht, ist hier noch über Stege 5a, 5b, 5c mit der Metallisierung des Anschlusspads 40 verbunden. Grundsätzlich reicht auch nur ein Steg für die Verbindung zwischen Durchkontaktierung und Anschlusspad.

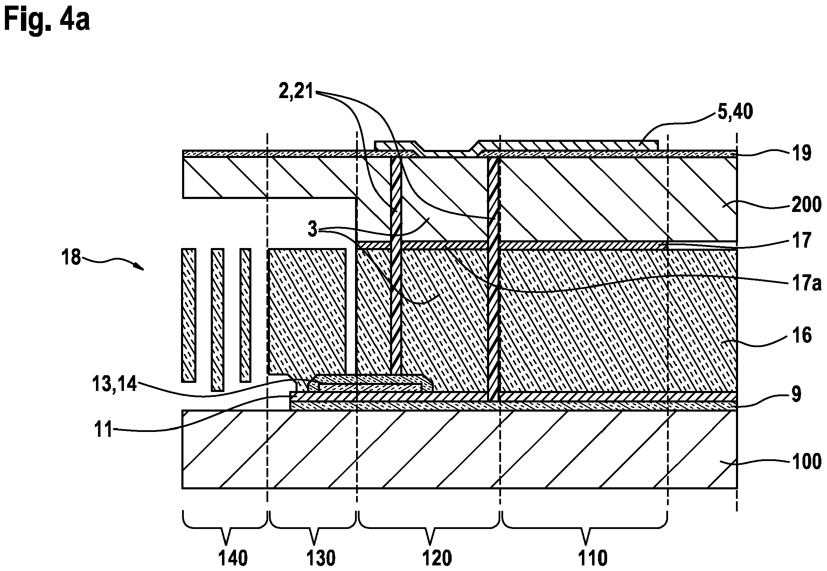

Wie bereits erwähnt, kann die voranstehend sehr ausführlich erläuterte Durchkontaktierung auch innerhalb eines vorzugsweise hochdotierten Kappenwafers realisiert werden. Ein Beispiel für diese Variante der Erfindung ist in Fig. 4a dargestellt.
Dabei handelt es sich ebenfalls um ein Beschleunigungssensorelement, dessen mikromechanische Funktionselemente 18 in einem Schichtaufbau auf einem Halbleitersubstrat 100 realisiert worden sind. Die mikromechanischen Funktionselemente 18 werden durch einen Kappenwafer 200 aus einem leitfähigen Material geschützt. Dieser Kappenwafer 200 wurde über eine Metallisierung 17, 17a in den Bereichen 110 des Bondrahmens und 120 der Durchkontaktierung auf den Schichtaufbau des Bauelements gebondet. Die elektrische Kontaktierung der mikromechanischen Funktionselemente 18 erfolgt über eine oder mehrere vergrabene Leiterbahnen 11, die durch dielektrische Schichten 9 und 13, 14 einerseits gegen das hochdotierte Halbleitersubstrat 100 und andererseits gegen die Funktionsschicht 16 elektrisch isoliert sind. Die Leiterbahn 11 stellt eine Verbindung zwischen den mikromechanischen Funktionselementen 18 und einem Anschlussbereich 3 her, der sich über die Funktionsschicht 16, die Metallisierung 17a und den Kappenwafer 200 erstreckt und durch einen zylindrischen Isolationsrahmen 2 gegen das angrenzende Schichtmaterial isoliert ist. Der Isolationsrahmen 2 ist erfindungsgemäß mit einem dielektrischen Polymer 21 verfüllt.

Der Isolationsrahmen 2 kann in einem einstufigen Trenchprozess nach dem Aufbonden des Kappenwafers 200 erzeugt werden. In diesem Fall empfiehlt es sich, die Metallisierung 17, 17a vor dem Aufbonden des Kappenwafers 200 entsprechend zu strukturieren. Der Isolationsrahmen 2 kann aber auch in zwei Stufen erzeugt werden, indem er bereits im Zuge der Strukturierung der Funktionsschicht 16 angelegt wird. Dann muss nach dem Bondprozess lediglich noch der Kappenwafer 200 getrencht werden. Dies erfordert allerdings eine Justierung bezüglich des Isolationsgrabens 2 in der Funktionsschicht 16. In beiden Fällen fungieren die dielektrischen Schichten 9 und 13, 14 als Trenchstopp.

Auf dem Kappenwafer 200 befindet sich eine strukturierte Metallisierung 5, die in unmittelbarem Kontakt zum Anschlussbereich 3 steht aber ansonsten durch eine dielektrische Schicht 19 gegen den Kappenwafer 200 elektrisch isoliert ist. Das Anschlusspad 40 zur externen Kontaktierung des Bauelements bzw. der Funktionselemente 18 ist hier seitlich von der Durchkontaktierung 3 angeordnet. Dazu war eine Umverdrahtung erforderlich, wie sie beispielsweise in Fig. 3b dargestellt ist.

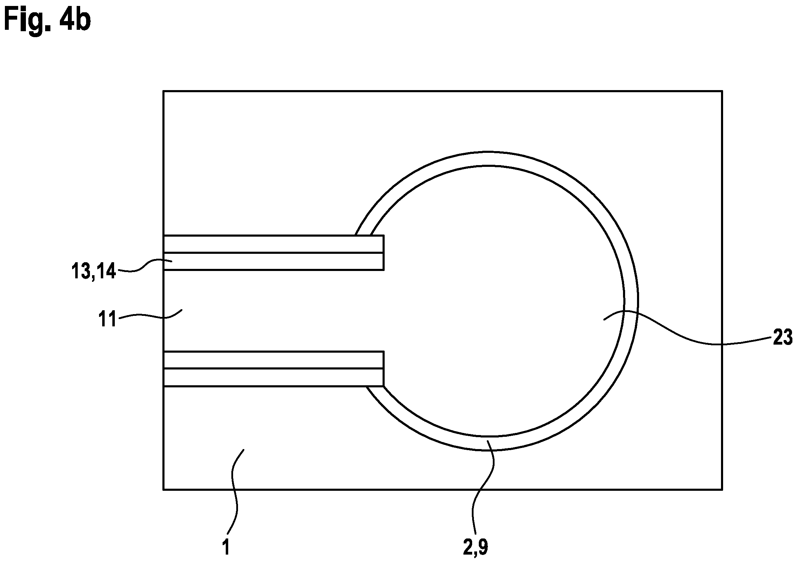

Fig. 4b veranschaulicht die elektrische Kontaktierung der mikromechanischen Funktionselemente 18 des in Fig. 4a dargestellten Bauelements anhand einer schematischen Draufsicht auf die Schichtebene der leitfähigen Polysiliziumschicht 1, in der eine vergrabene Leiterbahn 11 mit Verbindung zu den Funktionselementen 18 strukturiert ist. Im vorliegenden Ausführungsbeispiel ist die Durchkontaktierung 3 von einem Isolationsrahmen 2 mit kreisringförmigem Querschnitt umgeben. Wie in Fig. 4a zu erkennen, erstreckt sich der Isolationsrahmen 2 durch den Kappenwafer 200 und die Funktionsschicht 16 bis zur nächsten darunterliegenden dielektrischen Schicht 9 bzw. 13, 14. In dem Bereich, in dem der Isolationsrahmen 2 auf der dielektrischen Schicht 9 fußt, trennt er einen kreisrunden Anschlussbereich 23 von der Polysiliziumschicht 1 ab. Dieser Anschlussbereich 23 ist lediglich mit der Leiterbahn 11 verbunden. Da diese Leiterbahn 11 von den dielektrischen Schichten 13, 14 überlagert wird, durchtrennt der Isolationsrahmen 2 die Polysiliziumschicht 1 hier nicht sondern endet bereits auf den dielektrischen Schichten 13, 14.

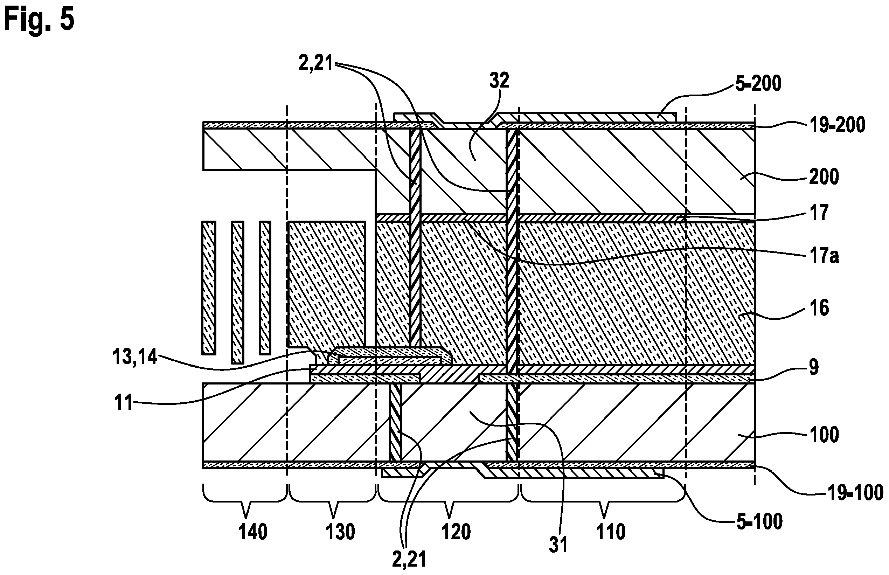

Das in Fig. 5 dargestellte Bauelement wurde mit zwei Durchkontaktierungen ausgestattet, nämlich mit einer Durchkontaktierung 31 im Substrat 100, wie sie in Fig. 2 dargestellt ist, und mit einer Durchkontaktierung 32 im Kappenwafer 200, wie sie in Fig. 4a dargestellt ist. Deshalb wird hier auf die Beschreibung der Figuren 2 und 4 verwiesen. Bei diesem Bauelement kann das Sensorsignal sowohl von der Bauelementrückseite ausgehend als auch über die Kappe 200 abgegriffen werden. Deshalb eignet es sich besonders für eine Anordnung innerhalb eines Bauelementstapels.

## Patentansprüche

1. Bauelement umfassend einen Schichtaufbau auf einem leitfähigen Substrat mit mindestens einer auf die Bauelemennückseite geführten Durchkontaktierung (Vertical Interconnect Access VIA) (3) zur elektrische Kontaktierung von im Schichtaufbau reallsierten Funktionselementen (18),
wobei die Durchkontaktierung (3) einen Anschlussbereich im Substrat (100) umfasst, der sich über die gesamte Substratdicke erstreckt und durch einen sich ebenfalls über die gesamte Substratdicke erstreckenden, grabenförmigen isolationsrahmen (2) gegenüber dem angrenzenden Substrat (100) elektrisch isoliert Ist, wobei der grabenförmige isolationsrahmen (2) mit einem elektrisch Isolierenden Polymer (21) verfüllt ist, **dadurch gekennzeichnet, dass** dem Polymer ein Füllstoff zugesetzt Ist.

2. Bauelement umfassend einen Schichtaufbau auf einem leitfähigen Substrat mit Funktionselementen, die in dem Schichtaufbau auf einem Substrat (100) realisiert sind, mit einem leitfähigen Kappensubstrat auf dem Schichtaufbau und mit mindestens einer durch das Kappensubstrat geführten Durchkontaktierung (Vertical interconnect Access VIA) (3) zur elektrischen Kontaktierung der Funktionselemente (18), wobei die Durchkontaktierung (3) einen Anschlussbereich umfasst, der sich über die gesamte Dicke des Kappensubstrats bis zu einer Anschlussleiterbahn im Schichtaufbau auf dem Substrate (100) erstreckt und durch einen grabenförmigen isolationsrahmen (2) gegenüber seiner Umgebung elektrisch Isoliert ist, und
wobei der grabenförmige isolationsrahmen (2) mit einem elektrisch isollerenden Polymer (21) verfüllt ist,
**dadurch gekennzeichnet, dass** dem Polymer ein Füllstoff zugesetzt ist.

3. Bauelement nach Anspruch 1 oder 2, **dadurch gekennzeichnet, dass** die Verfüllung (21) des isolationsrahmens (2) BCB (Benzocyclobuten), ein Polyimid und/oder PBO (Polyphenylen-2,6-benzobisoxazol) umfasst.

4. Bauelement nach einem der Ansprüche 1 oder 2, **dadurch gekennzeichnet, dass** der Füllstoff aus SiO2-Nanopartikel und/oder Metalloxid-Partikel besteht.

5. Bauelement nach einem der Ansprüche 1 bis 4, **dadurch gekennzeichnet, dass** der isolationsrahmen (2) der Durchkontaktierung (3) eine gerundete Geometrie aufweist, insbesondere zylinderförmig ist.

6. Bauelement nach einem der Ansprüche 1 bis 5, **dadurch gekennzeichnet, dass** der Querschnitt des isolationsrahmens (2) im Mittelbereich (24) und/oder im Fußbereich (20) gegenüber seinem Querschnitt im oberen Bereich erweitert Ist.

7. Bauelement nach einem der Ansprüche 1 bis 6, wobei die Durchkontaktierung (3) mit einer im Schichtaufbau auf dem Substrat (100) realisierten Polysillzlum-Leiterbahn (11) In Verbindung steht,
**dadurch gekennzeichnet, dass** die Grenzfläche (10) zwischen der Durchkontaktierung (3) und der Polysillzlum-Leiterbahn (11) eine vorzugsweise stufen-oder sickenartige Topograffe aufweist.

8. Bauelement nach einem der Ansprüche 1 bis 7, **dadurch gekennzeichnet, dass** die Durchkontaktierung (3) mit einer auf die Bauelementoberfläche aufgebrachten Metallisierung (5) in Verbindung steht und dass in der Metallisierung (5) ein Anschlusspad (30; 40) für die Durchkontaktierung ausgebildet ist, das direkt auf dem Anschlussbereich (3) oder mit Hilfe einer Umverdrahtung seitlich vom Anschlussbereich (3) angeordnet Ist.

9. Bauelement nach einem der Ansprüche 1 bis 8, wobei der Bauelementaufbau ein Kappensubstrat umfasst, **dadurch gekennzeichnet, dass** das Kappensubstrat auf den Schichtaufbau gebondet ist, wobei sich die Bondverbindung In einem Bereich befindet, wo die Oberflächentopgraphie wenige 100 nm sind und die Schichten des Schichtaufbaus geeignet strukturiert sind.

10. Verfahren zum Herstellen eines Bauelements mit einer Durchkontaktierung (3) ausgehend von einem Halbleitersubstrat (100),
- bei dem mindestens eine Leiterbahn (11) in einem Schichtaufbau auf dem Halbleitersubstrat (100) realisiert wird, die einerseits in unmittelbarem Kontakt zu mindestens einem Anschlussbereich (3) im Substrat (100) steht und andererseits eine elektrische Verbindung zu mindestens einem im Schichtaufbau zu realisierenden Funktionselement (18) herstellt,
- bei dem nach Fertigstellung des Schichtaufbaus in einem Rückseitentrenchprozess ein den Anschlussbereich (3) umgebender, sich über die gesamte Substratdicke erstreckender isolationsrahmen (2) im Substrat (100) erzeugt wird,
- bei dem der grabenförmige isolationsrahmen (2) mit einem elektrisch Isolierenden und einem Füllstoff aufweisenden Polymer (21) verfüllt wird, und
- bei dem eine strukturierte Metallisierung (5) auf die Bauelementrückseite aufgebracht wird, die mit dem Anschlussbereich (3) in Verbindung steht und in der mindestens ein Anschlusspad (30; 40) ausgebildet wird.

11. Verfahren nach Anspruch 10. bei dem die Metallisierung (5) vor dem Rückseitentrenchprozess auf die Bauelementrückseite aufgebracht und strukturiert wird, so dass sie eine Ätzmaske für den nachfolgend ausgeführten Rückseitentrenchprozess bildet.

12. Verfahren nach einem der Ansprüche 10 oder 11, **dadurch gekennzeichnet, dass** der Isolationsrahmen (2) in einem Mittelbereich (24) und/oder im Fußbereich (20) durch isotropes Ätzen erweitert wird.

13. Verfahren nach einem der Ansprüche 10 bis 12, **dadurch gekennzeichnet, dass** das Polymer (21) zum Verfüllen des isolationsrahmens (2) unter Vakuum-Bedingungen auf die Substratrückseite aufgeschleudert oder aufgesprüht wird.

14. Verfahren nach einem der Ansprüche 10 bis 13, **dadurch gekennzeichnet, dass** die Polymerverfüllung mittels Feinschleifen und/oder mittels chemisch mechanischen Poliers planarisiert wird.

## Claims

1. Component, comprising a layer structure on a conductive substrate,
having at least one via (Vertical Interconnect Access, VIA) (3), led onto the component back side, for electrically contacting functional elements (18) realized in the layer structure, wherein the via (3) comprises a connection area in the substrate (100), which extends over the entire substrate thickness and is electrically insulated from the adjoining substrate (100) by a trench-like insulating frame (2) likewise extending over the entire substrate thickness,
wherein the trench-like insulating frame (2) is filled with an electrically insulating polymer (21), **characterized in that** a filler is added to the polymer.

2. Component, comprising a layer structure on a conductive substrate, having functional elements which are realized in the layer structure on a substrate (100), having a conductive cap substrate on the layer structure, and having at least one via (Vertical Interconnect Access, VIA) (3), led through the cap substrate, for electrically contacting the functional elements (18),
wherein the via (3) comprises a connection area, which extends over the entire thickness of the cap substrate up to a connecting conductor track in the layer structure on the substrate (100) and is electrically insulated from its surroundings by a trench-like insulating frame (2), and
wherein the trench-like insulating frame (2) is filled with an electrically insulating polymer (21),
**characterized in that** a filler is added to the polymer.

3. Component according to Claim 1 or 2, **characterized in that** the filling (21) of the insulating frame (2) comprises BCB (benzocyclobutene), a polyimide and/or PBO (polyphenylene-2,6-benzobisoxazole).

4. Component according to either of Claims 1 and 2,
**characterized in that** the filler consists of SiO2 nanoparticles and/or metal oxide particles.

5. Component according to one of Claims 1 to 4,
**characterized in that** the insulating frame (2) of the via (3) has a rounded geometry, in particular is cylindrical.

6. Component according to one of Claims 1 to 5,
**characterized in that** the cross section of the insulating frame (2) in the central area (24) and/or in the base area (20) is widened with respect to its cross section in the upper area.

7. Component according to one of Claims 1 to 6, wherein the via (3) is connected to a polysilicon conductor track (11) realized in the layer structure on the substrate (100),
**characterized in that** the interface (10) between the via (3) and the polysilicon conductor track (11) has a preferably step-like or bead-like topography.

8. Component according to one of Claims 1 to 7,
**characterized in that** the via (3) is connected to a metallization (5) applied to the component surface, and **in that** a connection pad (30; 40) for the via is formed in the metallization (5) and is arranged directly on the connection area (3) or with the aid of a redistribution wiring laterally from the connection area (3).

9. Component according to one of Claims 1 to 8, wherein the component structure comprises a cap substrate, **characterized in that** the cap substrate is bonded onto the layer structure, wherein the bonding connection is located in an area where the surface topography measures a few 100 nm and the layers of the layer structure are suitably patterned.

10. Method for producing a component having a via (3) proceeding from a semiconductor substrate (100),
- in which at least one conductor track (11) is realized in a layer structure on the semiconductor substrate (100), and on the one hand is in direct contact with at least one connection area (3) in the substrate (100) and on the other hand produces an electrical connection to at least one functional element (18) to be realized in the layer structure,
- in which, after completion of the layer structure, an insulating frame (2) surrounding the connection area (3) and extending over the entire substrate thickness is produced in the substrate (100) in a back-side trenching process,
- in which the trench-like insulating frame (2) is filled with an electrically insulating polymer (21) comprising a filler, and
- in which a patterned metallization (5) is applied to the component back side and is connected to the connection area (3) and is formed in the at least one connection pad (30; 40).

11. Method according to Claim 10, in which the metallization (5) is applied to the component back side and patterned before the back-side trenching process, such that it forms an etching mask for the back-side trenching process subsequently carried out.

12. Method according to either of Claims 10 and 11, **characterized in that** the insulating frame (2) is widened by isotropic etching in a central area (24) and/or in the base area (20).

13. Method according to one of Claims 10 to 12, **characterized in that** the polymer (21) for filling the insulating frame (2) is applied to the substrate back side by spinning or spraying under vacuum conditions.

14. Method according to one of Claims 10 to 13, **characterized in that** the polymer filling is planarized by means of fine grinding and/or by means of chemical-mechanical polishing.

## Revendications

1. Composant comprenant une structure stratifiée sur un substrat conducteur avec au moins un contact traversant (Vertical Interconnect Access VIA) (3) mené sur le côté arrière du composant pour la mise en contact électrique d'éléments fonctionnels (18) réalisés dans la structure stratifiée, dans lequel le contact traversant (3) comprend une zone de raccordement dans le substrat (100), qui s'étend sur toute l'épaisseur du substrat et qui est électriquement isolée du substrat adjacent (100) par un cadre d'isolation (2) en forme de tranchées s'étendant également sur toute l'épaisseur du substrat, dans lequel le cadre d'isolation (2) en forme de tranchées est rempli d'un polymère électriquement isolant (21), **caractérisé en ce qu'**une matière de charge est ajoutée au polymère.

2. Composant comprenant une structure stratifiée sur un substrat conducteur avec des éléments fonctionnels, qui sont réalisés dans la structure stratifiée sur un substrat (100), avec un substrat supérieur conducteur sur la structure stratifiée et avec au moins un contact traversant (Vertical Interconnect Access VIA) (3) mené à travers le substrat supérieur pour la mise en contact électrique des éléments fonctionnels (18), dans lequel le contact traversant (3) comprend une zone de raccordement, qui s'étend sur toute l'épaisseur du substrat supérieur jusqu'à une voie conductrice de raccordement dans la structure stratifiée sur le substrat (100) et qui est isolée électriquement par rapport à son environnement au moyen d'un cadre d'isolation (2) en forme de tranchées, et dans lequel le cadre d'isolation (2) en forme de tranchées est rempli d'un polymère électriquement isolant (21), **caractérisé en ce qu'**une matière de charge est ajoutée au polymère.

3. Composant selon la revendication 1 ou 2, **caractérisé en ce que** le remplissage (21) du cadre d'isolation (2) comprend du BCB (benzocyclobutène), un polyimide et/ou du PBO (polyphénylène-2,6-benzobisoxazol).

4. Composant selon une des revendications 1 ou 2, **caractérisé en ce que** la matière de charge se compose de nanoparticules de SiO₂ et/ou de nanoparticules d'oxyde métallique.

5. Composant selon l'une quelconque des revendications 1 à 4, **caractérisé en ce que** le cadre d'isolation (2) du contact traversant (3) présente une géométrie arrondie, et est en particulier de forme cylindrique.

6. Composant selon l'une quelconque des revendications 1 à 5, **caractérisé en ce que** la section transversale du cadre d'isolation (2) dans la région moyenne (24) et/ou dans la région de pied (20) est élargie par rapport à sa section transversale dans la région supérieure.

7. Composant selon l'une quelconque des revendications 1 à 6, dans lequel le contact traversant (3) est en liaison avec une voie conductrice en polysilicium (11) réalisée dans la structure stratifiée sur le substrat (100), **caractérisé en ce que** la surface limite (10) entre le contact traversant (3) et la voie conductrice en polysilicium (11) présente une topographie de préférence étagée ou en forme de moulure.

8. Composant selon l'une quelconque des revendications 1 à 7, **caractérisé en ce que** le contact traversant (3) est en liaison avec une métallisation (5) déposée sur la surface du composant et **en ce qu'**une pastille de raccordement (30; 40) pour le contact traversant est formée dans la métallisation (5), laquelle est disposée directement sur la zone de raccordement (3) ou à l'aide d'un recâblage latéralement à la zone de raccordement (3).

9. Composant selon l'une quelconque des revendications 1 à 8, dans lequel la structure du composant comprend un substrat supérieur, **caractérisé en ce que** le substrat supérieur est métallisé sur la structure stratifiée, dans lequel la liaison par métallisation se trouve dans une région, où la topographie de la surface vaut quelques 100 nm et les couches de la structure stratifiée sont structurées de façon appropriée.

10. Procédé de fabrication d'un composant comportant un contact traversant (3) à partir d'un substrat semi-conducteur (100),
- dans lequel on réalise dans une structure stratifiée sur le substrat semi-conducteur (100) au moins une voie conductrice (11), qui se trouve d'une part en contact direct avec au moins une zone de raccordement (3) dans le substrat (100) et qui établit d'autre part une liaison électrique avec au moins un élément fonctionnel (18) à réaliser dans la structure stratifiée,
- dans lequel, après la réalisation de la structure stratifiée, on produit dans le substrat (100), par un procédé de creusement de tranchées dans le côté arrière, un cadre d'isolation (2) entourant la zone de raccordement (3) et s'étendant sur toute la hauteur du substrat,
- dans lequel on remplit le cadre d'isolation (2) en forme de tranchées avec un polymère (21) électriquement isolant et présentant une matière de charge, et
- dans lequel on dépose sur le côté arrière du composant une métallisation structurée (5), qui est en liaison avec la zone de raccordement (3) et dans laquelle au moins une pastille de raccordement (30; 40) est formée.

11. Procédé selon la revendication 10, dans lequel on dépose et on structure la métallisation (5) sur le côté arrière du composant avant le procédé de creusement de tranchées dans le côté arrière, de telle manière qu'elle forme un masque de gravure pour le procédé de creusement de tranchées dans le côté arrière exécuté ensuite.

12. Procédé selon une des revendications 10 ou 11, **caractérisé en ce que** l'on élargit le cadre d'isolation (2) dans une région moyenne (24) et/ou dans la région de pied (20) par gravure isotrope.

13. Procédé selon l'une quelconque des revendications 10 à 12, **caractérisé en ce que** l'on projette ou on pulvérise le polymère (21) pour le remplissage du cadre d'isolation (2) sur le côté arrière du substrat dans des conditions de vide.

14. Procédé selon l'une quelconque des revendications 10 à 13, **caractérisé en ce que** l'on aplanit le remplissage de polymère par meulage fin et/ou par polissage chimique-mécanique.
